# EUROPEAN PATENT APPLICATION

(11) **EP 4 482 276 A1**
(43) Date of publication of application: **25.12.2024**
(21) Application number: 23756603.9
(22) Date of filing: 14.02.2023
(51) Int. Cl.: H10K 50/854, H10K 59/38, H10K 50/11, H10K 85/00

(54) **LIGHT CONTROL MEMBER AND DISPLAY DEVICE COMPRISING SAME**

(30) Priority: 17.02.2022 KR 20220021083
(71) Applicant: Samsung Display Co., Ltd., Yongin-si, Gyeonggi-do 17113 (KR)
(72) Inventor: PAEK, Hye-Jin, Yongin-si Gyeonggi-do 17113 (KR); KWON, Sunyoung, Yongin-si Gyeonggi-do 17113 (KR); KWON, Youngsoo, Yongin-si Gyeonggi-do 17113 (KR); KIM, Buyong, Yongin-si Gyeonggi-do 17113 (KR); KIM, Soodong, Yongin-si Gyeonggi-do 17113 (KR); KIM, Jinwon, Yongin-si Gyeonggi-do 17113 (KR); PARK, Dahye, Yongin-si Gyeonggi-do 17113 (KR); SONG, Taeyoung, Yongin-si Gyeonggi-do 17113 (KR); OH, Keunchan, Yongin-si Gyeonggi-do 17113 (KR); LEE, Hyeokjin, Yongin-si Gyeonggi-do 17113 (KR)
(74) Representative: Marks & Clerk LLP
(86) International application number: PCT/KR2023/002150
(87) International publication number: WO 2023/158191

(57) **Abstract**

Provided are a light control member and a display device including the same that exhibit excellent light extraction efficiency and low reflection characteristics by including: a light control layer having a base resin region, and a light conversion region in which a plurality of light converters are aggregated, wherein each of the light converters includes: a quantum dot; and a liquid crystal ligand bonded to a surface of the quantum dot.

## Description

### TECHNICAL FIELD

The present disclosure herein relates to a light control member and a display device including the same.

### BACKGROUND ART

Display devices include a transmissive display device that selectively transmits source light generated from a light source, and a light emitting display device that generates source light from a display device itself. The display devices may include different types of light control parts according to pixels to generate color images. The light control parts may transmit only source light having a predetermined wavelength range or convert the color of source light. Some light control parts may change the properties of light without converting the color of source light.

In the display devices, quantum dot materials are used in the light control parts, and for the purpose of enhancing the display quality of the display devices, there is a need for developing technology that allows for an increase in light conversion efficiency or light transmission efficiency in the light control parts.

### DISCLOSURE OF THE INVENTION

### TECHNICAL PROBLEM

A purpose of the present invention is to provide a light control member with which reflectance of external light is reduced and which has excellent light extraction efficiency.

A purpose of the present invention is to provide a display device including a light control member with which reflectance of external light is reduced and which has satisfactory light scattering properties, thereby achieving excellent display quality.

### TECHNICAL SOLUTION

An embodiment of the inventive concept provides a light control member including: a light control layer including a base resin region, and a light conversion region in which a plurality of light converters are aggregated, wherein each of the light converters includes: a quantum dot; and a liquid crystal ligand bonded to a surface of the quantum dot.

In an embodiment, the base resin region and the light conversion region may have different refractive indices.

In an embodiment, the base resin region may include a polymer derived from at least one of an acrylate-based monomer or an epoxy-based monomer.

In an embodiment, the quantum dot may be a red quantum dot excited by blue light or green light to emit red light, or a green quantum dot excited by the blue light to emit green light.

In an embodiment, the liquid crystal ligand may be represented by Formula 1 below.

[Formula 1]

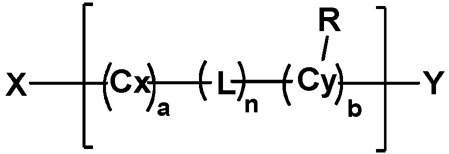

In Formula 1 above, a and b are each independently an integer of 1 to 3, n is 0 or 1, Cx and Cy are each independently a benzene ring or a cyclohexane ring, and L is a divalent ester (COO) group, a divalent ethylene group, a divalent methoxy group, a divalent acetylene group, or a divalent amine group. R is a hydrogen atom, a halogen atom, a cyano group, a hydroxy group, or a nitro group, and X and Y are each independently an alkyl group having 1 to 10 carbon atoms, an alkoxy group, a cyano group, or a halogen atom.

In an embodiment, the liquid crystal ligand may be represented by any one among LD-1 to LD-3 below, wherein in LD-1, R is the same as defined in Formula 1 above.

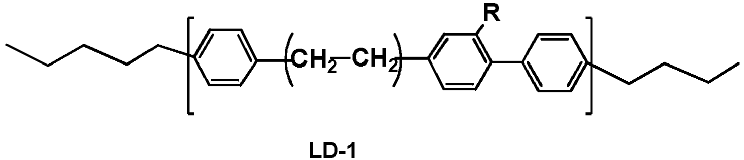

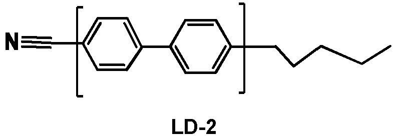

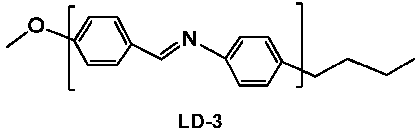

In an embodiment, the base resin region and the light conversion region may be portions that are phase-separated in a polymerization process of a light conversion resin composition containing the monomer and the light converters dispersed in the monomer.

In an embodiment, the light control layer may have a cross-section with a fingerprint pattern formed from the arrangement of the base resin region and the light conversion region that are separated.

In an embodiment, the light control layer may include a division pattern having a plurality of openings defined therein, and first to third light control parts disposed in each of the openings, wherein the first light control part may include the base resin region and a red light conversion region, the second light control part may include the base resin region and a green light conversion region, and the third light control part may include the base resin region and a ligand region in which the liquid crystal ligands are aggregated and disposed.

In an embodiment, the base resin region may have a refractive index different from that of the red light conversion region, that of the green light conversion region, and that of the ligand region.

In an embodiment, the red light conversion region may include a plurality of red light converters, and each of the red light converters comprises a red quantum dot excited by blue light or green light to emit red light and the liquid crystal ligand bonded to a surface of the red quantum dot, and the green light conversion region may include a plurality of green light converters, and each of the green light converters comprises a green quantum dot excited by the blue light to emit green light and the liquid crystal ligand bonded to a surface of the green quantum dot.

In an embodiment, the first light control part may contain the red light converters in an amount of about 20 wt% to about 60 wt% with respect to 100 wt% of a total weight of the first light control part, and the second light control part may contain the green light converters in an amount of about 20 wt% to about 60 wt% with respect to 100 wt% of a total weight of the second light control part.

In an embodiment, the third light control part may contain the liquid crystal ligand in an amount of about 5 wt% to about 10 wt% with respect to 100 wt% of a total weight of the third light control part.

In an embodiment, the light control member may further include a color filter layer disposed on the light control layer and including a first filter, a second filter, and a third filter that correspond to the first light control part, the second light control part, and the third light control part, respectively.

In an embodiment of the inventive concept, a display device includes a lower panel including a display element layer in which a light emitting region is defined; and an upper panel including a light control layer that is disposed on the lower panel and includes a division pattern having an opening overlapping the light emitting region defined therein and a light control part disposed in the opening, wherein the light control layer includes a base resin region, and a light conversion region in which a plurality of light converters are aggregated and disposed, each of the light converters including: a quantum dot; and a liquid crystal ligand bonded to a surface of the quantum dot.

In an embodiment, the base resin region and the light conversion region may have different refractive indices.

In an embodiment, the base resin region may include a polymer derived from at least one of an acrylate-based monomer or an epoxy-based monomer.

In an embodiment, the liquid crystal ligand may be represented by Formula 1 below.

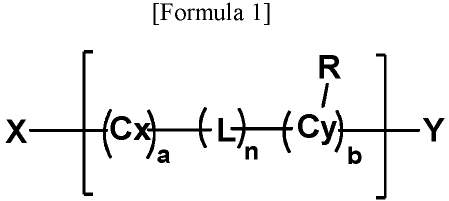

In Formula 1 above, a and b are each independently an integer of 1 to 3, n is 0 or 1, Cx and Cy are each independently a benzene ring or a cyclohexane ring, and L is a divalent ester (COO) group, a divalent ethylene group, a divalent methoxy group, a divalent acetylene group, or a divalent amine group. R is a hydrogen atom, a halogen atom, a cyano group, a hydroxy group, or a nitro group, and X and Y are each independently an alkyl group having 1 to 10 carbon atoms, an alkoxy group, a cyano group, or a halogen atom.

In an embodiment, the light control layer may have a cross-section with a fingerprint pattern formed from the arrangement of the base resin region and the light conversion region that are separated.

In an embodiment, the light control layer may include: a first light control part including the base resin region and a red light conversion region separated from the base resin region; a second light control part including the base resin region and a green light conversion region separated from the base resin region; and a third light control part including the base resin region, and a ligand region separated from the base resin region and having the liquid crystal ligands aggregated therein.

In an embodiment, the base resin region may have a refractive index different from that of the red light conversion region, that of the green light conversion region, and that of the ligand region.

In an embodiment, the first light control part may contain a plurality of red light converters in an amount of about 20 wt% to about 60 wt% with respect to 100 wt% of a total weight of the first light control part; the second light control part may contain a plurality of green light converters in an amount of about 20 wt% to about 60 wt% with respect to 100 wt% of a total weight of the second light control part; and the third light control part may contain the liquid crystal ligand in an amount of about 5 wt% to about 10 wt% with respect to 100 wt% of a total weight of the third light control part.

In an embodiment, the display element layer may include a light emitting element that includes a first electrode, an emission layer disposed on the first electrode, and a second electrode disposed on the emission layer, and outputs source light, the first light control part may include a first light converter that converts the source light into a first light, the second light control part may include a second light converter that converts the source light into a second light, and the third light control part may transmit the source light.

In an embodiment, the first light converter may include a first quantum dot excited by the source light to emit the first light, and the liquid crystal ligand bonded to a surface of the first quantum dot, and the second light converter may include a second quantum dot excited by the source light to emit the second light, and the liquid crystal ligand bonded to a surface of the second quantum dot.

In an embodiment, the upper panel may further include a filter layer disposed on an upper side of the light control layer, and including a first filter overlapping the first light control part and transmitting the first light, a second filter overlapping the second light control part and transmitting the second light, and a third filter overlapping the third light control part and transmitting the source light.

In an embodiment, the light control part may not include scatterers.

### ADVANTAGEOUS EFFECTS

A light control member according to an embodiment includes a base resin region and a light conversion region which are phase-separated to allow for satisfactory scattering of incident light, and may thus exhibit excellent light extraction efficiency, and does not include scatterers and may thus exhibit reduced reflectance of external light.

In addition, a display device according to an embodiment includes a light control part that does not include scatterers and is phase-separated into a base resin region and a light conversion region, and may thus have reduced reflectance of external light and increased light extraction efficiency, thereby exhibiting excellent display quality.

### BRIEF DESCRIPTION OF THE DRAWINGS

FIG. 1 is a perspective view of a display device according to an embodiment;
FIG. 2 is a cross-sectional view of a display device according to an embodiment;
FIG. 3 is a plan view showing a portion of a display device according to an embodiment;
FIG. 4 is a cross-sectional view showing a portion of a display device according to an embodiment;
FIG. 5 is a cross-sectional view showing a portion of a display device according to an embodiment;
FIG. 6 is a cross-sectional view of a light control layer according to an embodiment;
FIG. 7A is a view showing a portion of a light control part according to an embodiment;
FIG. 7B is a view showing a portion of a light control part according to an embodiment;
FIG. 8 is a view showing part of a method for manufacturing a light control part according to an embodiment;
FIG. 9 is a view showing a traveling direction of light in a light control part according to an embodiment as an example; and
FIG. 10 is a graph showing the relationship between light extraction efficiency and reflectance in Comparative Examples and Examples.

### MODE FOR CARRYING OUT THE INVENTION

The present disclosure may be modified in many alternate forms, and thus specific embodiments will be exemplified in the drawings and described in detail. It should be understood, however, that it is not intended to limit the present disclosure to the particular forms disclosed, but rather, is intended to cover all modifications, equivalents, and alternatives falling within the spirit and scope of the present disclosure.

In the present description, when an element (or a region, a layer, a portion, etc.) is referred to as being "on," "connected to," or "coupled to" another element, it means that the element may be directly disposed on/connected to/coupled to the other element, or that a third element may be disposed therebetween.

In the present description, "directly disposed" may indicate that there is no layer, film, region, plate or the like added between a portion of a layer, a film, a region, a plate or the like and other portions. For example, "directly disposed" may indicate disposing without additional members such as an adhesive member between two layers or two members. Like reference numerals refer to like elements.

In addition, in the drawings, the thickness, the ratio, and the dimensions of elements are exaggerated for an effective description of technical contents. The term "and/or," includes all combinations of one or more of which associated configurations may define.

It will be understood that, although the terms first, second, etc. may be used herein to describe various elements, these elements should not be limited by these terms. These terms are only used to distinguish one element from another element. For example, a first element may be referred to as a second element, and similarly, a second element may be referred to as a first element without departing from the teachings of the present disclosure. The singular forms are intended to include the plural forms as well, unless the context clearly indicates otherwise.

Also, terms of "below", "on lower side", "above", "on upper side", or the like may be used to describe the relationships of the components illustrated in the drawings. The terms are used as a relative concept and are described with reference to the direction indicated in the drawings. In the specification, being "disposed on" may represent not only being disposed on the top surface but also being disposed on the bottom surface.

It should be understood that the terms "comprise", or "have" are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined, all terms (including technical and scientific terms) used herein have the same meaning as commonly understood by one of ordinary skill in the art to which the inventive concept pertains. It is also to be understood that terms defined in commonly used dictionaries should be interpreted as having meanings consistent with the meanings in the context of the related art, and are expressly defined herein unless they are interpreted in an ideal or overly formal sense.

Hereinafter, a light control member according to an embodiment of the inventive concept and a display device including the same will be described with reference to the accompanying drawings.

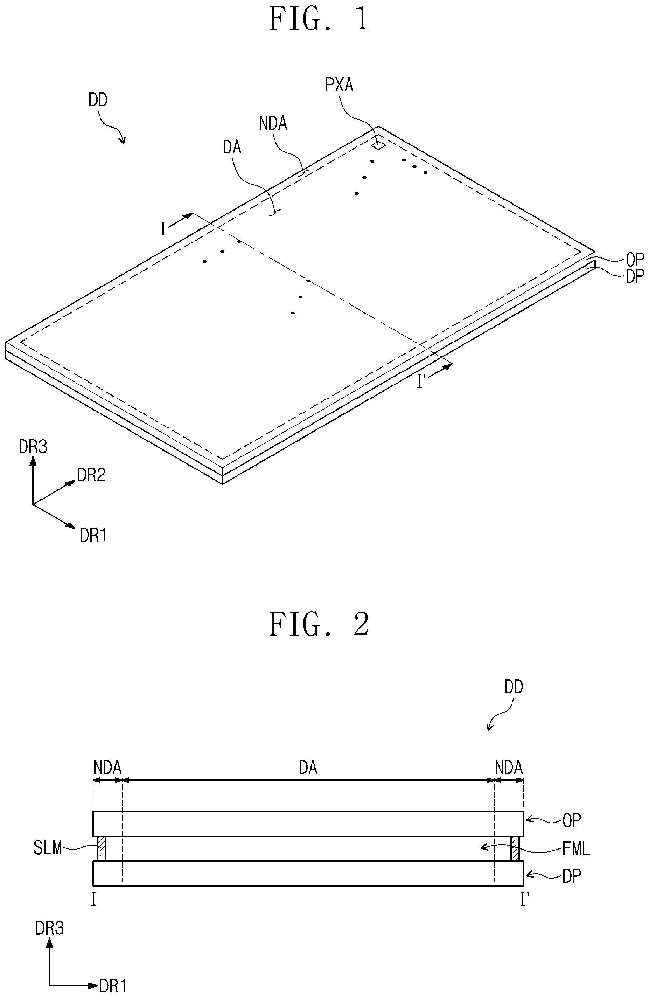

FIG. 1 is a perspective view of a display device according to an embodiment. FIG. 2 is a cross-sectional view showing a display device according to an embodiment. FIG. 2 is a cross-sectional view schematically showing a portion corresponding to line I-I' of FIG. 1.

A display device DD may be a device activated according to electrical signals. For example, the display device DD may be a mobile phone, a tablet, a car navigation system, a game console, or a wearable device, but the embodiment is not limited thereto.

Meanwhile, FIG. 1 and the following drawings show the first to third directional axes DR1 to DR3, and directions indicated by the first to third directional axes DR1, DR2, and DR3 described herein are relative concepts, and may thus be changed to other directions. In addition, the directions indicated by the first to third directional axes DR1, DR2, and DR3 may be described as first to third directions, and the same reference numerals may be used.

A thickness direction of the display device DD herein may be parallel to a third directional axis DR3 which is a normal direction to a plane defined by the first directional axis DR1 and the second directional axis DR2. As described herein, a front surface (or an upper surface) and a rear surface (or a lower surface) of members constituting the display device DD may be defined with respect to the third directional axis DR3.

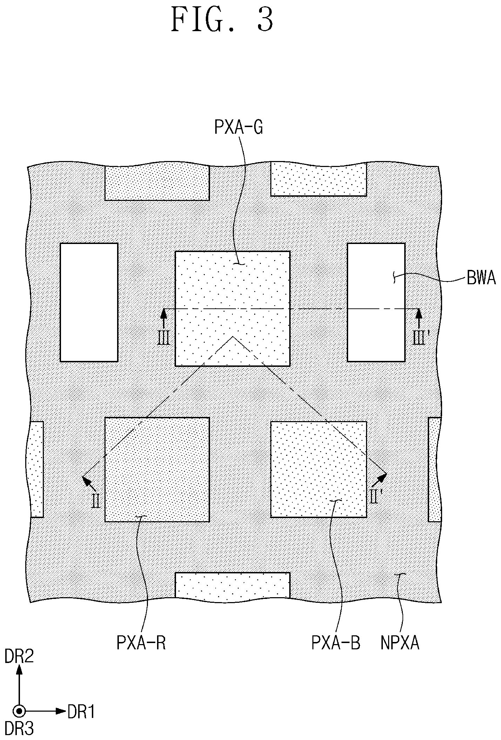

The display device DD according to an embodiment may include a display region DA and a non-display region NDA adjacent to the display region DA. The display region DA is a portion on which images are displayed. In the display region DA, a plurality of pixel regions PXA may be disposed. The plurality of pixel regions PXA may include first to third pixel regions PXA-R, PXA-G, and PXA-B (FIG. 3) that emit light of different wavelength ranges.

In an embodiment, the display region DA may have a tetragonal shape. The non-display region NDA may surround the display region DA. However, the embodiment of the inventive concept is not limited thereto, and the shape of the display region DA and the shape of the non-display region NDA may be relatively designed. In addition, the non-display region NDA may not be present on a display surface which is a front surface of the display device DD.

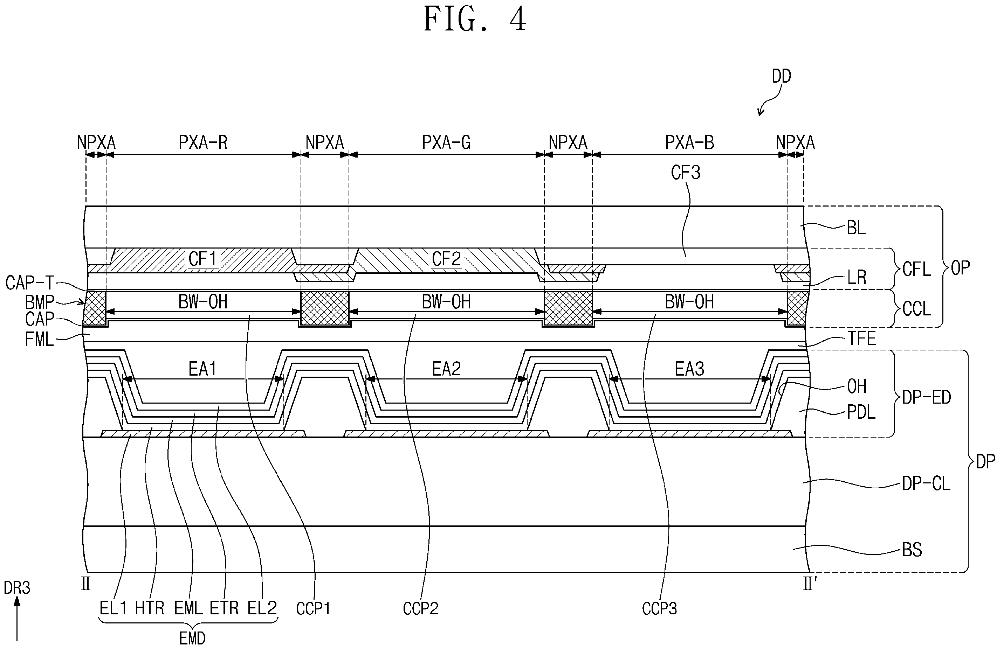

The display device DD according to an embodiment may include a lower panel DP having a display element layer DP-ED (FIG. 4), and an upper panel OP having a light control layer CCL (FIG. 4). In an embodiment, a filling layer FML may be disposed between the lower panel DP and the upper panel OP. In an embodiment, the lower panel DP may be referred to as a display panel or a display substrate, and the upper panel OP may be referred to as a light control member or a light control substrate.

In the display device DD according to an embodiment, the filling layer FML may fill a space between the lower panel DP and the upper panel OP. The filling layer FML may serve as a buffer between the lower panel DP and the upper panel OP. In an embodiment, the filling layer FML may have a shock absorbing function, etc., and may increase the strength of the display device DD. The filling layer FML may be formed from a filler resin including a polymer resin. For example, the filling layer FML may be formed from a filling layer resin including an acrylic resin or an epoxy-based resin.

Meanwhile, in an embodiment, the filling layer FML may be omitted, and the upper panel OP may be directly disposed on the lower panel DP. For example, in an embodiment, the filling layer FML may be omitted and the light control layer CCL (FIG. 4) may be disposed on the lower panel DP.

The display device DD according to an embodiment may include an encapsulation portion SLM disposed between the lower panel DP and the upper panel OP. The encapsulation portion SLM may bond the lower panel DP with the upper panel OP. The encapsulation portion SLM is disposed in the non-display region NDA and may thus bond the lower panel DP with the upper panel OP. The encapsulation portion SLM is disposed in the non-display region NDA, which is an outer portion of the display device DD, and may thus prevent foreign substances, oxygen, and moisture from being introduced into the display device DD from the outside. The encapsulation portion SLM may be formed from a sealant including a curable resin. The sealant may include an epoxy-based resin or an acrylic resin. The sealant may be a thermosetting material or a photocurable material. The sealant is provided on one surface of the lower panel DP or the upper panel OP, and thereafter the lower panel DP and the upper panel OP are bonded to face each other and then cured through heat or UV light to form the encapsulation portion SLM.

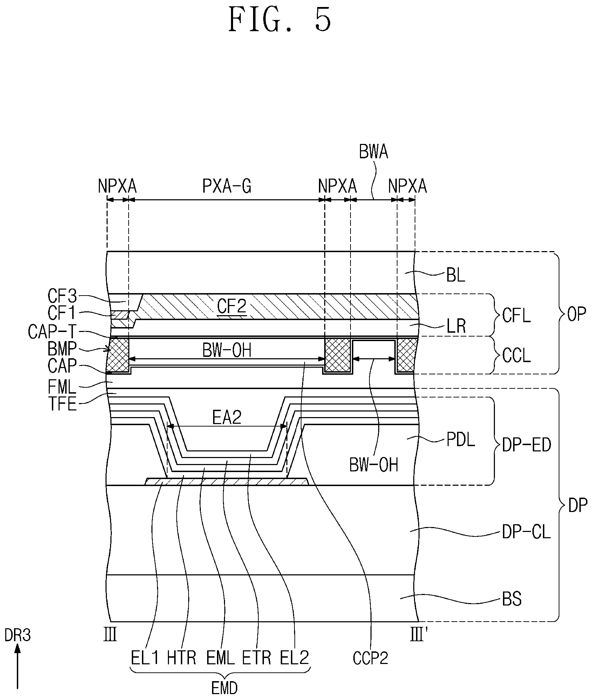

FIG. 3 is a plan view showing a portion of a display device according to an embodiment. FIG. 4 is a cross-sectional view of a display device according to an embodiment. FIG. 5 is a cross-sectional view showing a portion of a display device according to an embodiment. FIG. 4 is a cross-sectional view corresponding to line II-II' of FIG. 3, and FIG. 5 is a cross-sectional view corresponding to line III-III' of FIG. 3.

Referring to FIGS. 3 and 4, the display device DD may include a plurality of pixel regions PXA-R, PXA-G, and PXA-B. For example, the display device DD according to an embodiment may include a first pixel region PXA-R, a second pixel region PXA-G, and a third pixel region PXA-B, which are separated. The first pixel region PXA-R, the second pixel region PXA-G, and the third pixel region PXA-B may emit light of different wavelength ranges. For example, in an embodiment, the first pixel region PXA-R may be a red light emitting region emitting red light, the second pixel region PXA-G may be a green light emitting region emitting green light, and the third pixel region PXA-B may be a blue light emitting region emitting blue light. However, the embodiment is not limited thereto, and the plurality of pixel regions PXA-R, PXA-G, and PXA-B may include three groups of pixel regions that display three primary colors of yellow, magenta, and cyan.

In an embodiment, the pixel regions PXA-R, PXA-G, and PXA-B may be repeatedly disposed throughout the display region DA (FIG. 1). The first to third pixel regions PXA-R, PXA-G, and PXA-B may not overlap and be separated from each other when viewed on a plane. A peripheral region NPXA is disposed around the first to third pixel regions PXA-R, PXA-G, and PXA-B. The peripheral region NPXA sets boundaries between the first to third pixel regions PXA-R, PXA-G, and PXA-B. The peripheral region NPXA may surround the first to third pixel regions PXA-R, PXA-G, and PXA-B. A structure that prevents color mixing between the first to third pixel regions PXA-R, PXA-G, and PXA-B, for example, pixel defining layers PDL or division patterns BMP may be disposed in the peripheral region NPXA.

FIG. 3 shows, as an example, a display device DD that includes the first to third pixel regions PXA-R, PXA-G, and PXA-B having the same planar shape and having different planar areas, but the embodiment of the inventive concept is not limited thereto. The first to third pixel regions PXA-R, PXA-G, and PXA-B may all have an area of the same size, or at least one type of pixel region may have an area of a different size from the other types of pixel regions. The areas of the first to third pixel regions PXA-R, PXA-G, and PXA-B may be set according to the color of emitted light.

Referring to FIG. 3, the first to third pixel regions PXA-R, PXA-G, and PXA-B may have a rectangular shape when viewed on a plane. However, the embodiment is not limited thereto, and when view on a plane, the first to third pixel regions PXA-R, PXA-G, and PXA-B may have any other polygonal shapes (including substantially polygonal shapes) such as a rhombus or a pentagon. The first to third pixel regions PXA-R, PXA-G, and PXA-B may have a rectangular shape (a substantially rectangular shape) having rounded corners when viewed on a plane.

FIG. 3 shows, as an example, that the second pixel region PXA-G is disposed in a first row, and the first pixel region PXA-R and the third pixel region PXA-B are disposed in a second row, but the embodiment of the inventive concept is not limited thereto, and the arrangement of the first to third pixel regions PXA-R, PXA-G, and PXA-B may be variously changed. For example, the first to third pixel regions PXA-R, PXA-G, and PXA-B may be arranged in the same row.

For example, the plurality of pixel regions PXA-R, PXA-G, and PXA-B are arranged in the form of a stripe or may be arranged in the form of a pentile (PENTILE^{®}) or a diamond. However, the embodiment is not limited thereto, and the order and arrangement that the plurality of pixel regions PXA-R, PXA-G, and PXA-B are arranged come with varied combination according to display quality characteristics required for the display device DD.

Referring to FIGS. 3 and 5, the display device DD according to an embodiment may include a bank well area BWA. The bank well area BWA may be disposed between the pixel regions PXA-R, PXA-G, and PXA-B. When viewed on a plane, the bank well area BWA may not overlap the pixel regions PXA-R, PXA-G, and PXA-B. The bank well area BWA and the pixel regions PXA-R, PXA-G, and PXA-B may be separated by the division patterns BMP.

The bank well area BWA may be a portion corresponding to an opening BW-OH defined between the division patterns BMP to prevent defects resulting from mislanding of ink used in the process of patterning a plurality of light control parts CCP1, CCP2, and CCP3. The mislanding portion of the ink provided for forming the light control parts CCP1, CCP2, and CCP3 is disposed in the bank well area BWA, and accordingly, bonding failure caused by the mislanding of ink may be prevented. That is, although not shown herein, a portion of an ink composition for the forming of the light control parts CCP1, CCP2, and CCP3 may be disposed on at least a portion of the bank well area BWA.

The bank well area BWA may be defined to be adjacent to the pixel regions PXA-R, PXA-G, and PXA-B. The planar shape, number, and arrangement form of the bank well areas BWA are not limited to what is shown in FIG. 3 and are variously modifiable.

Referring to FIGS. 4 and 5, in an embodiment, the lower panel DP may include a base layer BS, a circuit layer DP-CL disposed on the base layer, and a display element layer DP-ED disposed on the circuit layer DP-CL. In addition, the lower panel DP may include an encapsulation layer TFE disposed on the display element layer DP-ED. The display element layer DP-ED may include pixel defining layers PDL and a light emitting element EMD. The encapsulation layer TFE may cover an upper portion of the display element layer DP-ED. The encapsulation layer TFE may fill a gap between the display element layer DP-ED and the filling layer FML.

In the display device DD according to an embodiment, the lower panel DP may be a light emitting display panel. For example, the lower panel DP may be an organic electroluminescence display panel. When the lower panel DP is an organic electroluminescence display panel, the display element layer DP-ED may include an organic electroluminescence element as the light emitting element EMD. However, the embodiment of the inventive concept is not limited thereto. For example, the display element layer DP-ED may include a quantum dot light emitting diode as the light emitting element EMD. In addition, the display element layer DP-ED may include a micro LED element and/or a nano LED element as the light emitting element EMD. The light emitting element EMD may generate source light. The source light generated and output from the light emitting element EMD may be provided to the upper panel OP, and the source light may be converted into light having a different wavelength in the light control layer CCL of the upper panel OP, or the source light may be scattered and transmitted.

In the lower panel DP, the base layer BS may be a member providing a base surface in which the display element layer DP-ED is disposed. The base layer BS may be a glass substrate, a metal substrate, a polymer substrate, or the like. However, the embodiment of the inventive concept is not limited thereto, and the base layer BS may be an inorganic layer, a functional layer, or a composite material layer.

The base layer BS may have a multilayer structure. For example, the base layer BS may have a three-layer structure of a polymer resin layer, an adhesive layer, and a polymer resin layer. In particular, the polymer resin layer may include a polyimide-based resin. In addition, the polymer resin layer may include at least one of an acrylic resin, a methacrylic resin, a polyisoprene-based resin, a vinyl-based resin, an epoxy-based resin, a urethane-based resin, a cellulose-based resin, a siloxane-based resin, a polyamide-based resin, or a perylene-based resin. Meanwhile, in the present description, a "~~based" resin may be considered as including a functional group of

The circuit layer DP-CL may be disposed on the base layer BS. The circuit layer DP-CL may include an insulating layer, a semiconductor pattern, a conductive pattern, a signal line, and the like. The insulating layer, the semiconductor layer, and the conductive layer are formed on the base layer BS through coating or deposition, and subsequently, the insulating layer, the semiconductor layer, and the conductive layer may be selectively patterned through multiple times of a photolithography process. Then, the semiconductor pattern, the conductive pattern, and the signal line included in the circuit layer DP-CL may be formed. In an embodiment, the circuit layer DP-CL may include a transistor, a buffer layer, and a plurality of insulating layers.

Referring to FIG. 4, the light emitting element EMD according to an embodiment may include a first electrode EL1, a second electrode EL2 facing the first electrode EL1, and an emission layer EML disposed between the first electrode EL1 and the second electrode EL2. The emission layer EML included in the light emitting element EMD may include organic light emitting materials or quantum dots as light emitting materials. The light emitting element EMD may further include a hole control layer HTR and an electron control layer ETR. Meanwhile, although not shown, the light emitting element EMD may further include a capping layer (not shown) disposed on an upper portion of the second electrode EL2.

The pixel defining layers PDL may be disposed on the circuit layer DP-CL and cover a portion of the first electrode EL1. Light emitting openings OH are defined in the pixel defining layers PDL. The light emitting openings OH of the pixel defining layers PDL allow at least a portion of the first electrode EL1 to be exposed. In the present embodiment, light emitting regions EA1, EA2, and EA3 are defined corresponding to a portion of the first electrode EL1 exposed through the light emitting openings OH.

The lower panel DP may include a first light emitting region EA1, a second light emitting region EA2, and a third light emitting region EA3. The first light emitting region EA1, the second light emitting region EA2, and the third light emitting region EA3 may be portions separated by the pixel defining layers PDL. The first light emitting region EA1, the second light emitting region EA2, and the third light emitting region EA3 may respectively correspond to the first pixel region PXA-R, the second pixel region PXA-G, and the third pixel region PXA-B. Meanwhile, as described herein, the term "correspond" indicates that two components overlap when viewed in the thickness direction DR3 of the display device DD, and this is not limited to the same area.

The light emitting regions EA1, EA2, and EA3 may overlap the pixel regions PXA-R, PXA-G, and PXA-B and may not overlap the bank well area BWA. When viewed on a plane, the pixel regions PXA-R, PXA-G, and PXA-B separated by the division patterns BMP may have a greater area than the light emitting regions EA1, EA2, and EA3 separated by the pixel defining layers PDL.

In the light emitting element EMD, the first electrode EL1 is disposed on the circuit layer DP-CL. The first electrode EL1 may be an anode or a cathode. In addition, the first electrode EL1 may be a pixel electrode. The first electrode EL1 may be a transmissive electrode, a transflective electrode, or a reflective electrode.

The hole control layer HTR may be disposed between the first electrode EL1 and the emission layer EML. The hole control layer HTR may include at least one of a hole injection layer, a hole transport layer, or an electron blocking layer. The hole control layer HTR may be disposed as a common layer to overlap the light emitting regions EA1, EA2, and EA3 and the entirety of the pixel defining layers PDL that separate the light emitting regions EA1, EA2, and EA3. However, the embodiment of the inventive concept is not limited thereto, and the hole control layer HTR may be provided through patterning so that the hole control layer HTR is separately disposed corresponding to each of the light emitting regions EA1, EA2, and EA3.

The emission layer EML is disposed on the hole control layer HTR. In an embodiment, the emission layer EML may be provided as a common layer to overlap the light emitting regions EA1, EA2, and EA3 and the entirety of the pixel defining layers PDL that separate the light emitting regions EA1, EA2, and EA3. In an embodiment, the emission layer EML may emit blue light. In the display device DD according to an embodiment, blue light may be source light.

The emission layer EML may overlap the entirety of the hole control layer HTR and the electron control layer ETR. However, the embodiment of the inventive concept is not limited thereto, and in an embodiment, the emission layer EML may be disposed in the light emitting openings OH. That is, the emission layers EML may be separately formed to correspond to the light emitting regions EA1, EA2, and EA3 which are separated by the pixel defining layers PDL. All of the emission layers EML separately formed to correspond to the light emitting regions EA1, EA2, and EA3 may emit light in the same wavelength range or may emit light in different wavelength ranges in each of the light emitting regions EA1, EA2, and EA3.

The emission layer EML may have a single layer formed of a single material, a single layer formed of a plurality of different materials, or a multilayer structure having a plurality of layers formed of a plurality of different materials. The emission layer EML may include a fluorescent material or a phosphorescent material. In the light emitting element according to an embodiment, the emission layer EML may include an organic light emitting material, a metal organic complex, or quantum dots as a light emitting material.

The electron control layer ETR may be disposed between the emission layer EML and the second electrode EL2. The electron control layer ETR may include at least one of an electron injection layer, an electron transport layer, or a hole blocking layer. Referring to FIG. 4, the electron control layer ETR may be disposed as a common layer to overlap the light emitting regions EA1, EA2, and EA3 and the entirety of the pixel defining layers PDL that separate the light emitting regions EA1, EA2, and EA3. However, the embodiment of the inventive concept is not limited thereto, and the electron control layer ETR may be provided through patterning so that the electron control layer ETR is separately disposed corresponding to each of the light emitting regions EA1, EA2, and EA3.

The second electrode EL2 is provided on the electron control layer ETR. The second electrode EL2 may be a common electrode. The second electrode EL2 may be a cathode or an anode but the embodiment of the inventive concept is not limited thereto. For example, when the first electrode EL1 is an anode, the second electrode EL2 may be a cathode, and when the first electrode EL1 is a cathode, the second electrode EL2 may be an anode. The second electrode EL2 may be a transmissive electrode, a transflective electrode, or a reflective electrode.

The encapsulation layer TFE may be disposed on the light emitting element EMD. For example, in an embodiment, the encapsulation layer TFE may be disposed on the second electrode EL2. In addition, when the light emitting element EMD includes a capping layer (not shown), the encapsulation layer TFE may be disposed on the capping layer (not shown). The encapsulation layer TFE may include at least one organic film and at least one inorganic film, and the inorganic film and the organic film may be alternately disposed. The encapsulation layer TFE may serve to protect the display element layer DP-ED from moisture/oxygen, and to prevent foreign substances such as dust particles from being introduced into the display element layer DP-ED.

The encapsulation layer TFE may be at least one inorganic film including at least one of silicon nitride, silicon oxynitride, or silicon oxide. In addition, the inorganic film may include titanium oxide, aluminium oxide, etc.

The encapsulation layer TFE may include an organic film disposed between inorganic films. The organic film may include an organic polymer material formed from an acrylate-based resin or the like. However, the embodiment of the inventive concept is not limited thereto.

Referring to FIG. 4, the display device DD according to an embodiment may be disposed on the lower panel DP and may include the upper panel OP having a light control layer CCL. The light control layer CCL may include a division pattern BMP and a plurality of light control parts CCP1, CCP2, and CCP3. In an embodiment, the upper panel OP may further include a base substrate BL and a color filter layer CFL. Meanwhile, in an embodiment, at least one of the base substrate BL or the color filter layer CFL may be omitted. For example, in an embodiment, the base substrate BL may be omitted, and the upper panel OP serving as a light control member may include the light control layer CCL and the color filter layer CFL disposed on the light control layer CCL.

The light control parts CCP1, CCP2, and CCP3 included in the light control layer CCL may be spaced apart from each other. The light control parts CCP1, CCP2, and CCP3 may be disposed to be spaced apart from each other by the division pattern BMP. The light control parts CCP1, CCP2, and CCP3 may be disposed in the openings BW-OH defined in the division pattern BMP. However, the embodiment of the inventive concept is not limited thereto. In FIG. 4, the division pattern BMP is shown to non-overlap the light control parts CCP1, CCP2, and CCP3, but edges of the light control parts CCP1, CCP2, and CCP3 may overlap at least a portion of the division pattern BMP.

The light control parts CCP1, CCP2, and CCP3 may be portions that convert a wavelength of light provided from the display element layer DP-ED, or that transmit light without converting a wavelength of the provided light. The light control parts CCP1, CCP2, and CCP3 may be formed through an inkjet process. A liquid ink composition may be provided in the openings BW-OH, and the provided ink composition may be polymerized through a thermal curing process or a photo-curing process to form the light control parts CCP1, CCP2, and CCP3.

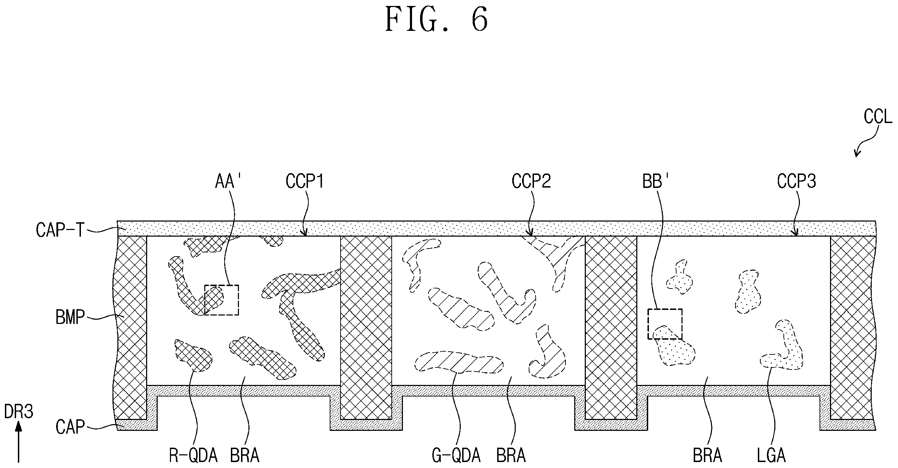

The light control layer CCL may include a base resin region BRA (FIG. 6) and light conversion regions R-QDA and G-QDA (FIG. 6), which are phase-separated. In addition, the light control layer CCL may include a base resin region BRA (FIG. 6) and a ligand region LGA (FIG. 6), which are phase-separated. The first light control part CCP1 may be a portion that converts source light generated and provided from the light emitting element EMD into first color light, and the second light control part CCP2 may be a portion that converts source light generated and provided from the light emitting element EMD into second color light. The third light control part CCP3 may be a portion that transmits light in a wavelength region corresponding to source light. For example, in an embodiment, the source light may be blue light, the first color light may be red light, and the second color light may be green light. However, the embodiment of the inventive concept is not limited thereto, and in a range satisfying the conditions that the second color light has a longer central wavelength than the source light and the first color light has a longer central wavelength than the second color light, colors of the source light and the emitted first and second color light may change. The light control parts CCP1, CCP2, and CCP3 included in the light control layer CCL according to an embodiment will be described in more detail later.

The light control layer CCL may further include barrier layers CAP and CAP-T disposed on at least one of an upper portion or a lower portion of the light control parts CCP1, CCP2, and CCP3. The barrier layers CAP and CAP-T may serve to prevent penetration of moisture and/or oxygen (hereinafter, referred to as moisture/oxygen). The barrier layers CAP and CAP-T may be disposed on the upper portion and the lower portion of the light control parts CCP1, CCP2, and CCP3 to prevent the light control parts CCP1, CCP2, and CCP3 from being exposed to moisture/oxygen.

The barrier layers may include a first barrier layer CAP positioned adjacent to a filling layer FML, and a second barrier layer CAP-T spaced apart from the filling layer FML with the light control parts CCP1, CCP2, and CCP3 therebetween. The first barrier layer CAP may cover one surface of the light control parts CCP1, CCP2, and CCP3 positioned adjacent to the lower panel DP, and the second barrier layer CAP-T may cover the other surface of the light control parts CCP1, CCP2, and CCP3 positioned adjacent to the color filter layer CFL. In addition, the barrier layers CAP and CAP-T may cover the division pattern BMP as well as the light control parts CCP1, CCP2, and CCP3.

The first barrier layer CAP may be disposed to follow a stepped portion between the division pattern BMP and the light control parts CCP1, CCP2, and CCP3. The second barrier layer CAP-T may cover one surface of the division pattern BMP and the light control parts CCP1, CCP2, and CCP3, which are adjacent to the color filter layer CFL. The second barrier layer CAP-T may be directly disposed on a lower portion of a low refractive layer LR.

The barrier layers CAP and CAP-T may include at least one inorganic layer. That is, the barrier layers CAP and CAP-T may be formed including an inorganic material. For example, the barrier layers CAP and CAP-T may be formed including silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, or a metal thin film in which light transmittance is secured, etc. For example, the first barrier layer CAP disposed on the lower portion of the light control parts CCP1, CCP2, and CCP3 may include silicon oxynitride, and the second barrier layer CAP-T disposed on the upper portion of the light control parts CCP1, CCP2, and CCP3 may include silicon oxide. However, the embodiment of the inventive concept is not limited thereto. Meanwhile, the barrier layer CAP and CAP-T may further include an organic film. The barrier layers CAP and CAP-T may be formed of a single layer or a plurality of layers.

In the display device DD of an embodiment, the upper panel OP may include the color filter layer CFL disposed on the light control layer CCL. The color filter layer CFL may include filters CF1, CF2, and CF3. That is, the color filter layer CFL may include a first filter CF1 transmitting first color light, a second filter CF2 transmitting second color light, and a third filter CF3 transmitting light in a wavelength range corresponding to source light. For example, the first filter CF1 may be a red filter, the second filter CF2 may be a green filter, and the third filter CF3 may be a blue filter. The filters CF1, CF2, and CF3 may each include a polymer photosensitive resin, a pigment or a dye. The first filter CF1 may include a red pigment or a red dye, the second filter CF2 may include a green pigment or a green dye, and the third filter CF3 may include a blue pigment or a blue dye. Meanwhile, the embodiment of the inventive concept is not limited thereto, and the third filter CF3 may not include a pigment or a dye. The third filter CF3 may include a polymer photosensitive resin, but not include a pigment or a dye. The third filter CF3 may be transparent. The third filter CF3 may be formed of a transparent photosensitive resin.

In addition, in an embodiment, the first filter CF1 and the second filter CF2 may be yellow filters. The first filter CF1 and the second filter CF2 may not be separated and may be provided as a single body. The first to third color filters CF1, CF2, and CF3 may respectively correspond to the first pixel region PXA-R, the second pixel region PXA-G, and the third pixel region PXA-B. In addition, the first to third color filters CF1, CF2, and CF3 may respectively be disposed corresponding to the first to third light control parts CCP1, CCP2, and CCP3.

In addition, the plurality of filters CF1, CF2, and CF3 that transmit different color light corresponding to the peripheral regions NPXA disposed between the pixel regions PXA-R, PXA-G, and PXA-B may be disposed to overlap each other. The plurality of filters CF1, CF2, and CF3 may be disposed overlapping each other in the third direction DR3, which is the thickness direction, to define boundaries between the adjacent light emitting regions PXA-R, PXA-G, and PXA-B. Meanwhile, unlike what is shown, the color filter layer CFL may include a light blocking unit (not shown) that serves to define boundaries between the adjacent filters CF1, CF2, and CF3. The light blocking unit (not shown) may be formed of a blue filter or may be formed including an organic light blocking material or an inorganic light blocking material, both including a black pigment or a black dye. The color filter layer CFL may include the low refractive layer LR. The low refractive layer LR may be disposed between the light control layer CCL and the filters CF1, CF2, and CF3. The low refractive layer LR may be disposed on the upper portion of the light control layer CCL to prevent the light control parts CCP1, CCP2, and CCP3 from being exposed to moisture/oxygen. In addition, the low refractive layer LR may serve as a light functional layer that is disposed between the light control parts CCP1, CCP2, and CCP3 and the filters CF1, CF2, and CF3 to increase light extraction efficiency or prevent reflected light from being incident on the light control layer CCL. The low refractive layer LR may have a smaller refractive index than a layer adjacent thereto.

The low refractive layer LR may include at least one inorganic layer. For example, the low refractive layer LR may be formed including silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, or a metal thin film in which light transmittance is secured, etc. However, the embodiment is not limited thereto, and the low refractive layer LR may include an organic layer. For example, the low refractive layer LR may be formed including a polymer resin and inorganic particles. The low refractive layer LR may be formed of a single layer or a plurality of layers.

Meanwhile, in the display device DD according to an embodiment, the filters CF1, CF2, and CF3 of the color filter layer CFL may be directly disposed on the light control layer CCL. In this case, the low refractive layer LR may be omitted.

In an embodiment, the upper panel OP may further include a base substrate BL disposed on the color filter layer CFL. The base substrate BL may be a member providing a base surface on which the color filter layer CFL and the light control layer CCL are disposed. The base substrate BL may be a glass substrate, a metal substrate, a plastic substrate, etc. However, the embodiment of the inventive concept is not limited thereto, and the base substrate BL may be an inorganic layer, an organic layer, or a composite material layer. In addition, unlike what is shown, the base substrate BL may be omitted in an embodiment.

The division pattern BMP may include a material having a transmittance of a predetermined value or less. For example, the division pattern BMP may include a black coloring agent to block light. The division pattern BMP may include a black dye and a black pigment mixed with a base resin. In an embodiment, the black coloring agent may include carbon black, a metal such as chromium, or an oxide thereof.

An opening BW-OH may be defined in the division pattern BMP. The opening BW-OH may correspond to the pixel regions PXA-R, PXA-G, and PXA-B or the bank well area BWA. Meanwhile, the opening BW-OH defined to correspond to the pixel regions PXA-R, PXA-G, and PXA-B may overlap a light emitting opening OH. When viewed on a plane, the opening BW-OH may have a larger area than the light emitting opening OH. However, the embodiment of the inventive concept is not limited thereto.

FIG. 6 is a cross-sectional view of a light control layer according to an embodiment. FIG. 6 may show a portion of the upper panel OP (FIG. 4) according to an embodiment. The light control layer according to an embodiment shown in FIG. 6 may be included in a light control member according to an embodiment.

Referring to FIG. 6, the light control layer CCL according to an embodiment may include light control parts CCP1 and CCP2 separated into a base resin region BRA and light conversion regions R-QDA and G-QDA. In addition, the light control layer CCL according to an embodiment may further include a light control part CCP3 separated into a base resin region BRA and a ligand region LGA.

In an embodiment, the first light control part CCP1 may include a base resin region BRA and a red light conversion region R-QDA that converts source light into first color light, and the second light control part CCP2 may include a base resin region BRA and a green light conversion region G-QDA that converts source light into second color light. The source light may be generated and provided from the light emitting element EMD included in the lower panel DP (FIG. 4) in the display device according to an embodiment described above, and the source light may be blue light, the first color light may be red light, and the second color light may be green light.

In the light control layer CCL, the first light control part CCP1 may include a first quantum dot that converts the source light provided from the light emitting element EMD (FIG. 4) into the first color light, and the second light control part CCP2 may include a second quantum dot that converts the source light into the second color light. The third light control unit CCP3 may be a portion that transmits the source light. For example, in an embodiment, the first light control part CCP1 may emit red light, which is the first color light, and the second light control part CCP2 may emit green light, which is the second color light. The third light control part CCP3 may transmit and emit at least a portion of the source light provided from the light emitting element EMD (FIG. 4). In an embodiment, the first quantum dot may be a red quantum dot, and the second quantum dot may be a green quantum dot.

The base resin region BRA included in the light control parts CCP1, CCP2, and CCP3 may include a polymer derived from at least one of an acrylate-based monomer, a urethane-based monomer, or an epoxy-based monomer. The base resin region BRA may include an acrylic polymer resin, a urethane-based polymer resin, or an epoxy-based polymer resin.

For example, in an embodiment, the monomer may include at least one of lauryl acrylate, lauryl methacrylate, hydroxypropyl methacrylate, 3,5,5-trimethylhexyl acrylate, glycidyl methacrylate, tetrahydrofurfuryl acrylate, tetrahydrofurfuryl methacrylate, benzyl methacrylate, benzyl methacrylate, or cyclohexyl methacrylate. However, the embodiment of the inventive concept is not limited thereto.

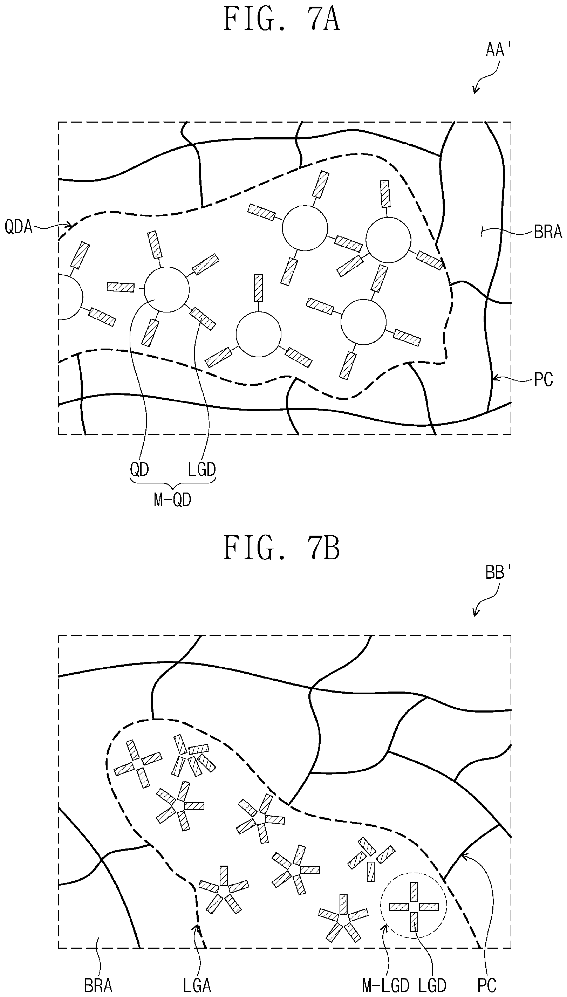

The base resin region BRA may be a portion formed through polymerization of at least one of an acrylate-based monomer, a urethane-based monomer, or an epoxy-based monomer by heat or UV light. The base resin region BRA may include a polymer chain PC (FIGS. 7A and 7B) formed through polymerization of a monomer. The polymer chain PC (FIGS. 7A and 7B) may form a network in the base resin region BRA.

FIG. 7A is a view showing a portion of a light control layer according to an embodiment. FIG. 7A may show a portion corresponding to region AA' of FIG. 6. Meanwhile, the descriptions of the portions shown in FIG. 7A may be equally applied to the second light control part CCP2 of FIG. 6. In FIG. 7A, the light conversion region QDA may correspond to the red light conversion region R-QDA of the first light control part CCP1, and the green light conversion region G-QDA of the second light control part CCP2 in FIG. 6.

Referring to FIG. 7A, the light control part CCP may include the base resin region BRA and the light conversion region QDA separated as a different region from the base resin region BRA. The light conversion region QDA may include a light converter M-QD including a quantum dot QD and a liquid crystal ligand LGD bonded to a surface of the quantum dot QD.

FIG. 7A schematically shows the form of the light converter M-QD, and the number of liquid crystal ligands LGD bonded to the surface of the quantum dot QD is not limited to what is shown. In an embodiment, in the light conversion region QDA, the light converters M-QD may be disposed in the form of being aggregated. In each of the light conversion regions R-QDA and G-QDA shown in FIG. 6, a plurality of light converters M-QD may be disposed in the form of being aggregated. Meanwhile, in the red light conversion region R-QDA, the red quantum dot and light converters including a liquid crystal ligand bonded to a surface of the red quantum dot may be disposed, and in the green light conversion region G-QDA, the green quantum dot and light converters including a liquid crystal ligand bonded to a surface of the green quantum dot may be disposed.

In an embodiment, the quantum dot QD may have a core-shell structure, and the core of the quantum dots may be selected from a Group II-VI compound, a Group III-VI compound, a Group I-III-VI compound, a Group III-V compound, a Group IV-VI compound, a Group IV element, a Group IV compound, and a combination thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and a mixture thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof.

The Group III-VI compound may include a binary compound such as In₂S₃ and In₂Se₃, a ternary compound such as InGaS₃ and InGaSe₃, or any combination thereof.

The Group I-III-VI compound may include a ternary compound selected from the group consisting of AgInS, AgInS₂, CuInS, CuInS₂, AgGaS₂, CuGaS₂ CuGaO₂, AgGaO₂, AgAlO₂, or any mixture thereof, or a quaternary compound such as AgInGaS₂ and CuInGaS₂.

The Group III-V compound may be selected from the group consisting of a binary compound selected from the group consisting of GaN, GaP, GaAs, GaSb, AlN, AlP, AlAs, AlSb, InN, InP, InAs, InSb, and a mixture thereof, a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof, and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof. Meanwhile, the Group III-V compound may further include a Group II metal. For example, InZnP, etc. may be selected as a Group III-II-V compound.

The Group IV-VI compound may be selected from the group consisting of a binary compound selected from the group consisting of SnS, SnSe, SnTe, PbS, PbSe, PbTe, and a mixture thereof, a ternary compound selected from the group consisting of SnSeS, SnSeTe, SnSTe, PbSeS, PbSeTe, PbSTe, SnPbS, SnPbSe, SnPbTe, and a mixture thereof, and a quaternary compound selected from the group consisting of SnPbSSe, SnPbSeTe, SnPbSTe, and a mixture thereof. The Group IV element may be selected from the group consisting of Si, Ge, and a mixture thereof. The Group IV compound may be a binary compound selected from the group consisting of SiC, SiGe, and a mixture thereof.

In this case, a binary compound, a ternary compound, or a quaternary compound may be present in particles in a uniform concentration distribution, or may be present in the same particles in a partially different concentration distribution. In addition, a core-shell structure in which one quantum dot surrounds another quantum dot may be present. The core-shell structure may have a concentration gradient in which the concentration of an element present in the shell becomes lower towards the core.

In some embodiments, the quantum dot QD may have the core-shell structure including a core having nano-crystals, and a shell surrounding the core, which are described above. The shell of the quantum dot may serve as a protection layer to prevent the chemical deformation of the core so as to keep semiconductor properties, and/or a charging layer to impart electrophoresis properties to the quantum dot. The shell may be a single layer or multiple layers. Examples of the shell of the quantum dot may be a metal or non-metal oxide, a semiconductor compound, or a combination thereof.

For example, the metal or non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and NiO, or a ternary compound such as MgAl₂O₄, CoFe₂O₄, NiFe₂O₄, and CoMn₂O₄, but the embodiment of the inventive concept is not limited thereto.

In addition, the semiconductor compound may be, for example, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc., but the embodiment of the inventive concept is not limited thereto.

The quantum dot QD may have a full width of half maximum (FWHM) of a light emission wavelength spectrum of about 45 nm or less, preferably about 40 nm or less, more preferably about 30 nm or less, and color purity or color reproducibility may be enhanced in the above ranges. In addition, light emitted through such a quantum dot is emitted in all directions, and thus a wide viewing angle may be improved.

In addition, the form of the quantum dot QD is not particularly limited as long as it is a form commonly used in the art, but more specifically, a quantum dot in the form of spherical, pyramidal, multi-arm, or cubic nanoparticles, nanotubes, nanowires, nanofibers, nanoplatelets, etc. may be used.

The quantum dot QD may control the color of emitted light according to the particle size thereof, and thus the quantum dot QD may have various light emission colors such as blue, red, green, etc. The smaller the particle size of the quantum dot QD becomes, light in the short wavelength region may be emitted. For example, in the quantum dot QD having the same core, the particle size of the quantum dot emitting green light may be smaller than the particle size of the quantum dot emitting red light. In addition, in the quantum dot QD having the same core, the particle size of the quantum dot emitting blue light may be smaller than the particle size of the quantum dot emitting green light. However, the embodiment of the inventive concept is not limited thereto, and even in the quantum dot having the same core, the particle size may be adjusted according forming-materials and thickness of a shell.

Meanwhile, when the quantum dot QD has various light emission colors such as blue, red, green, etc., the quantum dot having different light emission colors may have different core materials.

In an embodiment, the first light control part CCP1 may include a first quantum dot excited by source light to emit first light, and a first light converter having a liquid crystal ligand bonded to a surface of the first quantum dot, and the second light control part CCP2 may include a second quantum dot excited by source light to emit second light and a second light converter having a liquid crystal ligand bonded to a surface of the second quantum dot. That is, in the red light conversion region R-QDA, the red quantum dot and light converters M-QD having the liquid crystal ligand bonded to a surface of the red quantum dot may be disposed, and in the green light conversion region G-QDA, the green quantum dot and light converters M-QD having the liquid crystal ligand bonded to a surface of the green quantum dot may be disposed.

In an embodiment, the light converters M-QD may include the liquid crystal ligand LGD bonded to a surface of the quantum dot QD. When the quantum dot QD has a core-shell structure, the liquid crystal ligand LGD may be bonded to a surface of the shell. The liquid crystal ligand LGD may have a liquid crystal molecular structure, and the liquid crystal ligand LGD may have refractive anisotropy due to characteristics of liquid crystal molecules having different lengths of a major axis and a minor axis. Accordingly, the light converters M-QD having the liquid crystal ligand LGD may have high light scattering properties. In an embodiment, the liquid crystal ligand LGD bonded to the surface of the quantum dot QD may scatter light emitted from the quantum dot QD.

In addition, the liquid crystal ligand LGD may increase the aggregation of the light converters M-QD. The light converters M-QD having the liquid crystal ligand LGD may be closely aligned through the interaction between the liquid crystal ligands LGD, and accordingly a plurality of light converters M-QD may be aggregated to form a light conversion region QDA that is separated from the base resin region BRA.

Referring to FIGS. 6 and 7A, in each of the first light control part CCP 1 and the second light control part CCP2, the base resin region BRA and the light conversion regions R-QDA and G-QDA may have different refractive indices. That is, the base resin region BRA and the red light conversion region R-QDA may have different refractive indices, and the base resin region BRA and the green light conversion region G-QDA may have different refractive indices.

In an embodiment, the first light control part CCP1 and the second light control part CCP2 may be phase-separated into two distinct regions having different refractive indices. Boundaries defining the light conversion regions R-QDA and G-QDA may be defined by the neighboring base resin region BRA. The base resin region BRA and the light conversion regions R-QDA and G-QDA may be separated and arranged randomly. For example, the arrangement of the two regions separated into the base resin region BRA and the light conversion regions R-QDA and G-QDA may have a fingerprint pattern. The base resin region BRA and the light conversion region R-QDA and G-QDA may each be arranged randomly or may have an extended deformed lamellar structure and be arranged irregularly, and the light conversion regions R-QDA and G-QDA may form domains using the base resin region BRA as a matrix and be separated.

Light incident on the first light control part CCP1 and the second light control part CCP2 may have a light path altered at the boundary between the base resin region BRA and the light conversion regions R-QDA and G-QDA that have different refractive indices. Accordingly, the light incident on the first light control part CCP1 and the second light control part CCP2 may be scattered in various directions in the first light control part CCP1 and the second light control part CCP2. In an embodiment, the first light control part CCP1 and the second light control part CCP2 may be sufficiently excited by source light scattered in various directions to emit the light-converted light, thereby exhibiting high light extraction efficiency.

FIG. 7B is a view showing a portion of a light control layer according to an embodiment. FIG. 7B may show a portion corresponding to region BB' of FIG. 6.

Referring to FIG. 6 and FIG. 7A, the third light control part CCP3 may include the base resin region BRA and the ligand region LGA separated as a different region from the base resin region BRA. The ligand region LGA may be a portion in which a plurality of liquid crystal ligands LGD are aggregated and disposed. The ligand region LGA may include ligand aggregation M-LGD in which a plurality of liquid crystal ligands LGD are aggregated.

Through the aggregation taken place by interaction between the liquid crystal ligands LGD, the ligand region LGA that is separated from the base resin region BRA may be formed in the third light control part CCP3.

Each of the liquid crystal ligands LGD forming the ligand aggregation M-LGD may have a liquid crystal molecular structure, and may have refractive anisotropy due to characteristics of liquid crystal molecules having different lengths of a major axis and a minor axis. Accordingly, the ligand aggregation M-LGD including the liquid crystal ligands LGD may have high light scattering properties. In addition, in an embodiment, the base resin region BRA and the ligand region LGA included in the third light control part CCP3 may have different refractive indices, and accordingly, the light incident on the third light control part CCP3 may alter a light path thereof at individual ligand aggregation M-LGD or at the boundaries between the base resin region BRA and the ligand region LGA, and thus be effectively scattered.

Referring to FIGS. 6 and 7B, in the third light control part CCP3, the base resin region BRA and the ligand region LGA may have different refractive indices. In an embodiment, the third light control part CCP3 may be phase-separated into two distinct regions having different refractive indices. Boundaries defining the ligand region LGA may be defined by the neighboring base resin region BRA. The base resin region BRA and the ligand region LGA may be separated and arranged randomly. For example, the arrangement of the two regions separated into the base resin region BRA and the ligand region LGA may have a fingerprint pattern. The base resin region BRA and the ligand region LGA may each be arranged randomly or may have an extended deformed lamellar structure and be arranged irregularly, and the ligand region LGA may form domains using the base resin region BRA as a matrix and be separated. Meanwhile, in the case of the third light control part CCP3, the base resin region BRA of the light control part may have a greater area than those of the first and second light control parts CCP1 and CCP2.

Light incident on the third light control part CCP3 may have a light path altered at the boundary between the base resin region BRA and the ligand region LGA that have different refractive indices. Accordingly, the light incident on the third light control part CCP3 may be scattered in various directions. In an embodiment, the third light control part CCP3 may have an increased light transmission efficiency.

In FIGS. 7A and 7B, liquid crystal ligands LGD included in the light converter M-QD and liquid crystal ligands LGD constituting the ligand aggregation M-LGD may each be represented by Formula 1 below.

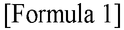

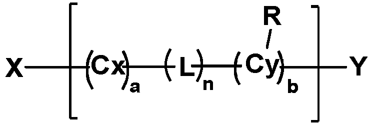

In Formula 1 above, a and b are each independently an integer of 1 to 3, and n is 0 or 1. Cx and Cy are each independently a benzene ring or a cyclohexane ring, and L is a divalent ester (COO) group, a divalent ethylene group, a divalent methoxy group, a divalent acetylene group, or a divalent amine group. In addition, R is a hydrogen atom, a halogen atom, a cyano group, a hydroxy group, or a nitro group, and X and Y are each independently an alkyl group having 1 to 10 carbon atoms, an alkoxy group, a cyano group, or a halogen atom.

In the liquid crystal ligand LGD represented by Formula 1, X and Y may be terminal groups, and any one of them may be a portion bonded to a surface of the quantum dot QD. The terminal group of any one of X and Y may be bonded to the surface of the quantum dot QD and the other terminal group may be adjacent to a liquid crystal ligand LGD portion of the neighboring light converter M-QD or may be adjacent to the base resin region BRA.

A portion represented by "L" in Formula 1 may be a linker. The linker may be a portion that links neighboring ring groups. In addition, in an embodiment, the linker portion may be omitted.

For example, in an embodiment, the liquid crystal ligand LGD may be represented by any one among LD-1 to LG-3 below. Meanwhile, in LD-1, R is the same as defined in Formula 1.

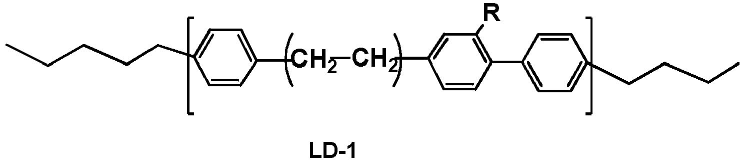

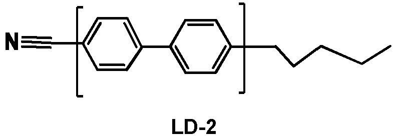

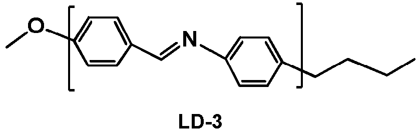

Referring to FIGS. 6 and 7A, in the light control layer CCL according to an embodiment, the first and second light control parts CCP1 and CCP2 may include the base resin region BRA and the light conversion regions R-QDA and G-QDA that are phase-separated as different domains from the base resin region BRA and include the light converter M-QD, and may thus exhibit excellent light extraction efficiency. The light incident to the first light control part CCP1 and the second light control part CCP2 may effectively alter a light path due to a difference in refractive indices between the base resin region BRA and the light conversion regions R-QDA and G-QDA, and accordingly the entire light converter M-QD may be excited effectively. In addition, the light excited by the incident light, converted from the light converter M-QD, and emitted may be effectively scattered and emitted at the boundaries between the liquid crystal ligand LGD, and the base resin region BRA and the light conversion regions R-QDA and G-QDA. Accordingly, the light control layer CCL including the base resin region BRA and the light conversion regions R-QDA and G-QDA that are phase-separated and have different refractive indices may exhibit excellent light extraction efficiency.

In addition, referring to FIGS. 6 and 7B, in the light control layer CCL according to an embodiment, the third light control part CCP3 may include the base resin region BRA and the ligand region LGA phase-separated as a different domain from the base resin region BRA and including the ligand aggregation M-LGD, and may thus exhibit excellent light extraction efficiency. The light incident on the third light control part CCP3 may alter a light path due to a difference in refractive index between the base resin region BRA and the ligand region LGA, and refractive anisotropy of the liquid crystal ligand LGD, and may thus be effectively scattered and emitted. Accordingly, the light control layer CCL including the base resin region BRA and the ligand region LGA that are phase-separated and have different refractive indices may exhibit excellent light extraction efficiency.

Meanwhile, in an embodiment, the light control layer CCL may not include scatterers. The first light control part CCP1 and the second light control part CCP2 may be formed of the base resin region BRA including a polymer, and the light conversion region QDA in which light converters formed of quantum dots and liquid crystal ligands are arranged, and may not include scatterers. In addition, the third light control part CCP3 may be formed of the base resin region BRA including a polymer, and the ligand region LGA formed of liquid crystal ligands, and may not include scatterers. That is, in an embodiment, the light control layer CCL may be a portion that does not include scatterers of inorganic particles such as TiO₂, ZnO, Al₂O₃, SiO₂, or hollow silica.

The light control layer CCL according to an embodiment may not include scatterers such as inorganic particles, and thus prevent a phenomenon in which external light incident on the light control parts CCP1, CCP2, CCP3 is reflected from the scatterers, thereby exhibiting low external light reflectance. That is, the light control layer CCL according to an embodiment may not include scatterers and thus exhibit low reflectance, and may include the first and second light control parts CCP1 and CCP2 having the base resin region BRA and the light conversion region QDA that are phase-separated, and a base resin region BRA and a ligand region LGA that are phase-separated, thereby exhibiting excellent light extraction efficiency together.

In addition, the light control layer CCL according to an embodiment may not include scatterers in a resin composition used for manufacturing the light control parts CCP1, CCP2, and CCP3, and may thus prevent irregularities caused by the degree of sedimentation of scatterers in the resin composition supplied through a nozzle. Accordingly, in the light control parts CCP1, CCP2, and CCP3 of an embodiment formed from the resin composition not including scatterers, poor appearance due to a difference in the distribution of scatterers may be prevented. In addition, in the resin composition not including scatterings, clogging due to scatterers in the nozzle that supplies the resin composition may be prevented to increase production efficiency of a light control layer.

In an embodiment, the first light control part CCP1 may contain about 20 wt% to about 60 wt% of red light converters with respect to 100 wt% of a total weight of the first light control part CCP1. The second light control part CCP2 may contain about 20 wt% to about 60 wt% of green light converters with respect to 100 wt% of a total weight of the second light control part CCP2. The red light converters and the green light converters are each supposed to include quantum dots and liquid crystal ligands bonded to the surface of the quantum dots. In an embodiment, each of the first light control part CCP1 and the second light control part CCP2 may contain light converters in a weight ratio of about 20 wt% to about 60 wt% and may thus effectively phase-separate the base resin region BRA and the light conversion regions R-QDA and G-QDA, thereby exhibiting required color reproducibility and light extraction efficiency.

In addition, in an embodiment, the third light control part CCP3 may include liquid crystal ligands in an amount of about 5 wt% to about 10 wt% with respect to 100 wt% of a total weight of the third light control part CCP3. In an embodiment, the third light control part CCP3 may include liquid crystal ligands in a weight ratio of about 5 wt% to about 10 wt%, and may thus effectively phase-separate the base resin region BRA and the ligand region LGA, thereby exhibiting excellent light extraction efficiency.

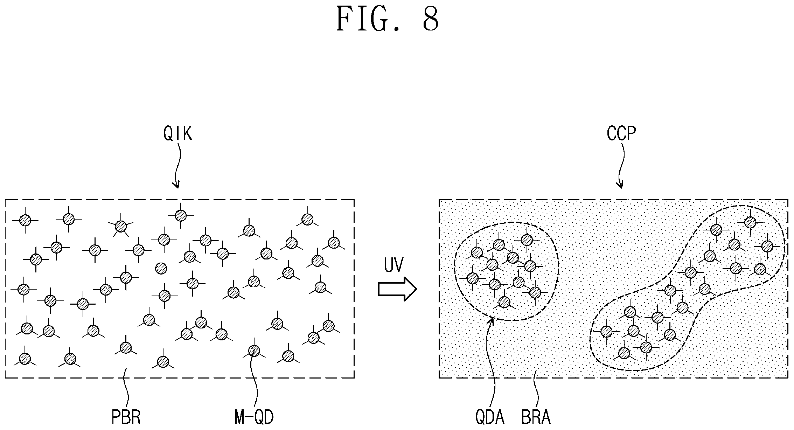

FIG. 8 is a view showing part of a method for manufacturing a light control part according to an embodiment as an example.

Referring to FIG. 8, a light conversion resin composition QIK including a monomer PBR and light converters M-QD dispersed in the monomer PBR are polymerized to form a light control part CCP including a base resin region BRA and a light conversion region QDA.

The polymerization of the light conversion resin composition QIK may be performed using ultraviolet light (UV). However, the embodiment of the inventive concept is not limited thereto, and the polymerization of the light conversion resin composition QIK may be performed using heat.

In the polymerization process of the light conversion resin composition QIK, according to the polymerization of the monomer PBR, the base resin region BRA, which is a polymer rich phase containing a polymer formed from the polymerization of a monomer and the light conversion region QDA, which is a QD rich phase formed of aggregated light converters M-QD may be divided and phase-separated. That is, the light conversion resin composition QIK may be phase-separated into the base resin region BRA and the light conversion region QDA through polymerization-induced phase separation (PIPS).

Meanwhile, although not shown, in the third light control part CCP3 (FIG. 6) as well, according to the polymerization of a monomer, the monomer and liquid crystal ligands dispersed in the monomer may each be divided and phase-separated into the base resin region BRA, which is a polymer rich phase, and the ligand region LGA, which is a ligand rich phase. That is, the base resin region BRA and the ligand region LGA in the third light control part CCP3 (FIG. 6) may also be portions formed by being divided through polymerization-induced phase separation (PIPS).

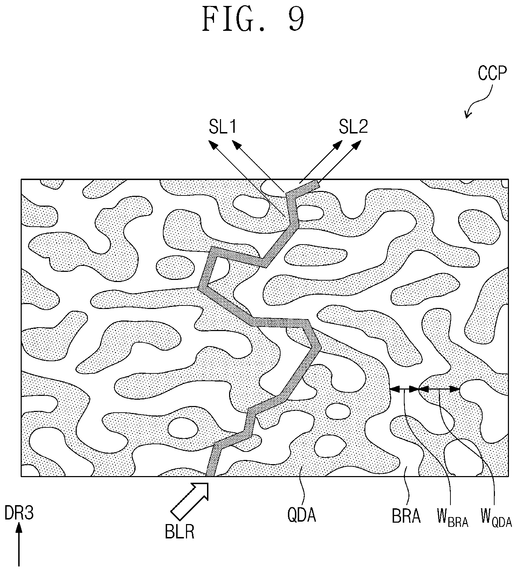

FIG. 9 is a view showing light extraction in a light control part according to an embodiment as an example. Referring to FIG. 9, the light control part CCP according to an embodiment may include a base resin region BRA and a light conversion region QDA which are separated. The light control part CCP parallel to the third directional axis DR3 may have a cross-section with a fingerprint pattern formed from the arrangement of the base resin region BRA and the light conversion region QDA that are separated. That is, the light control part CCP according to an embodiment may exhibit a pattern formed by randomly arranging two domains having different physical/chemical properties while defining boundaries between them. For example, a cross-section of the light control part CCP may be in the form shown in FIG. 9, but this is only an example, and the light control part CCP may have a cross-section in which two distinct domains are randomly crossed and arranged.

Widths W_{BRA} and W_{QDA} in one cross-section of the base resin region BRA and the light conversion region QDA constituting the fingerprint pattern of one cross-section of the light control part CCP may each be about 1 µm. For example, the widths W_{BRA} and W_{QDA} in one cross-section of the base resin region BRA and the light conversion region QDA may each be about 1 µm or less. When considering the degree of light scattering according to particle size in consideration of Mie scattering peak, in the case that the two regions of the base resin region BRA and the light conversion region QDA that have different refractive indices each have a width of about 1 µm or less, the degree of light scattering in the light control part CCP may be increased.

Meanwhile, as the base resin region BRA and the light conversion region QDA each are randomly formed after being induced in the process of polymerization, the widths W_{BRA} and W_{QDA} in one cross-section may be an average value of the widths W_{BRA} of each of the base resin regions BRA, and an average value of the widths W_{QDA} of each of the light conversion regions QDA, which are measured with respect to one direction (e.g., herein a direction perpendicular to the third direction DR3).

Light BLR incident on the light control part CCP according to an embodiment may be bent and advanced at the boundaries between the base resin region BRA and the light conversion region QDA. The light BLR incident in one direction may be bent and transmitted in different directions while passing through the light control part CCP, and directions SL1 and SL2 of emitted light may be varied in two or more directions. Accordingly, the light control part CCP according to an embodiment does not include scatterers, but may exhibit excellent light scattering properties and light extraction efficiency due to altered light paths resulting from a difference in refractive index in two different regions.

Table 1 below shows the results of evaluating optical properties in light control parts of Comparative Example and Example. Comparative Example and Example were each manufactured to have a film thickness of 9 µm.

A resin composition used for manufacturing the light control part of Comparative Example includes acrylic monomers, quantum dots, and TiO₂ and a resin composition used for manufacturing the light control part of Example includes acrylic monomers and light converters, but does not include TiO₂. The light converters of Example are ones in which liquid crystal ligands are bonded to the quantum dots used in Comparative Example.

In Table 1, light absorption indicates absorption of light provided to the light control parts of Comparative Example and Example, and light extraction efficiency indicates the proportion of light emitted from the light control parts to the provided light. Reflectance indicates SCI reflectance in the light control parts of Comparative Example and Example when external light is provided. Whether or not phase separation takes place is observed using FIB-SEM images of phase separation in the light control parts after polymerization of the resin compositions.

[Table 1]

| Item | Elements of resin composition | Light absorption | Light extraction efficiency | Reflectance | Presence of phase separation |
|---|---|---|---|---|---|
| Com parat ive Exa mple | Acrylic monomer 55wt%, Quantum dot 41%, TiO₂ 4wt% | 81% | 30.7% | 24% | X |
| Exa mple | Acrylic monomer 55wt%, Light converter 45%, | 82% | 32.5% | 21% | O |

Referring to the results of Table 1, it is seen that Example exhibits a similar light absorption as compared to Comparative Example, and exhibits phase-separated characteristics. In addition, it is seen that the light control part of Example exhibits light extraction efficiency equal to or higher than that of the light control part of Comparative Example, and exhibits reflectance that is reduced by 10% or greater compared to Comparative Example. That is, based on the results of Table 1, it is seen that the light control part of Example including two regions not including scatterers to be phase-separated and divided exhibits excellent light extraction efficiency and reduced reflectance compared to the light control part including existing scatterers.

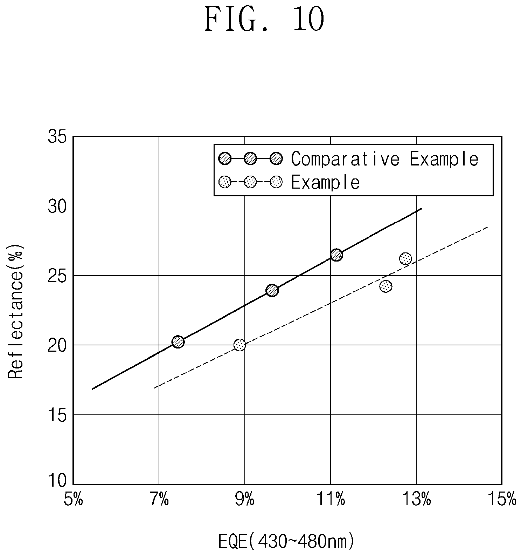

FIG. 10 is a graph showing the characteristics of light control parts of Comparative Example and Example. Comparative Example and Example in FIG. 10 are shown by evaluating the reflectance of the light control parts provided between division patterns BMP (FIG. 4). In FIG. 10, an axis of X corresponds to light conversion efficiency (EQE) converted into light in the wavelength range of about 430 nm to about 480 nm, and an axis of Y corresponds to relative reflectance of the light control parts of Comparative Example and Example when SCI reflectance in the division patterns BMP (FIG. 4) is set to 1%. The light control parts of Comparative Example and Example used in FIG. 10 each correspond to light control parts formed of the resin compositions of Comparative Example and Example in Table 1 described above.

Referring to FIG. 10, it is seen that, when the light conversion efficiency (EQE) is the same, the light control part of Example exhibits lower external light reflectance than the light control part of Comparative Example. That is, at the same light conversion efficiency (EQE), the SCI reflectance of the light control part of Example may be reduced by 10% or greater with respect to the reflectance of the light control part of Comparative Example.

That is, it is seen that compared to a light control layer including an existing light control part that includes scatterers, a light control layer according to an embodiment not including scatterers but including phase-separated regions exhibits remarkably reduced reflection of external light in the case of having the same level of light extraction efficiency.

The light control member according to an embodiment described with reference to FIGS. 6 to 10 includes a light control layer having a base resin region and a light conversion region in which a plurality of light converters are aggregated to provide excellent light extraction efficiency, and does not include scatterers to provide reduced reflectance.

The display device DD according to an embodiment described with reference to FIGS. 1 to 5 may include an upper panel OP having the light control layer according to an embodiment described above. For the light control layer CCL included in the upper panel OP of the display device DD, the descriptions described with reference to FIGS. 6 to 10 may be equally applied.

The light control member of an embodiment includes a base resin region and a light conversion region which are separated, and the light conversion region includes light converters containing quantum dots and liquid crystal ligands to exhibit satisfactory light extraction efficiency and low reflectance. In addition, the display device according to an embodiment includes a base resin region and a light conversion region on a lower panel having a display element layer, and the light conversion region includes an upper panel having light converters containing quantum dots and liquid crystal ligands to accomplish high light extraction efficiency and low reflectance, thereby exhibiting excellent display quality.

Although described with reference to preferred embodiments of the present disclosure, it will be understood that various changes and modifications of the present disclosure may be made by one ordinary skilled in the art or one having ordinary knowledge in the art without departing from the spirit and technical field of the present disclosure as hereinafter claimed.

Hence, the technical scope of the present disclosure is not limited to the detailed descriptions in the specification but should be determined only with reference to the claims.

### INDUSTRIAL APPLICABILITY

Quantum dot materials are used in the light control part of display devices, and in order to improve the display quality of the display device, there is a need to develop technology to increase light conversion efficiency or light transmission efficiency in the light control part. The light control member of the present invention includes a base resin region and a light conversion region that are separated from each other, and the light conversion region includes light converters including quantum dots and liquid crystal ligands, and can exhibit good light extraction efficiency and low reflection characteristics. In addition, the display device of the present invention includes a base resin region and a light conversion region on a lower panel including a display element layer, and the light conversion region includes an upper panel including light converters including quantum dots and liquid crystal ligands. This enables high light extraction efficiency and low-reflection characteristics to provide excellent display quality. Therefore, the present invention has high industrial applicability.

## Claims

1. A light control member comprising:
a light control layer including a base resin region, and a light conversion region in which a plurality of light converters are aggregated,
wherein each of the light converters includes:
a quantum dot; and
a liquid crystal ligand bonded to a surface of the quantum dot.

2. The light control member of claim 1, wherein the base resin region and the light conversion region have different refractive indices.

3. The light control member of claim 1, wherein the base resin region comprises a polymer derived from at least one of an acrylate-based monomer or an epoxy-based monomer.

4. The light control member of claim 1, wherein the quantum dot is a red quantum dot excited by blue light or green light to emit red light, or a green quantum dot excited by the blue light to emit green light.

5. The light control member of claim 1, wherein the liquid crystal ligand is represented by Formula 1 below: 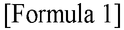 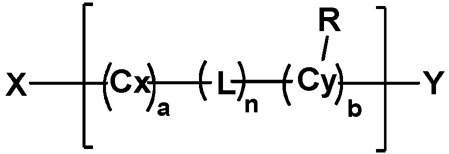
wherein in Formula 1 above,
a and b are each independently an integer of 1 to 3,
n is 0 or 1,
Cx and Cy are each independently a benzene ring or a cyclohexane ring,
L is a divalent ester (COO) group, a divalent ethylene group, a divalent methoxy group, a divalent acetylene group, or a divalent amine group,
R is a hydrogen atom, a halogen atom, a cyano group, a hydroxy group, or a nitro group, and
X and Y are each independently an alkyl group having 1 to 10 carbon atoms, an alkoxy group, a cyano group, or a halogen atom.

6. The light control member of claim 5, wherein the liquid crystal ligand is represented by any one among LD-1 to LD-3 below: 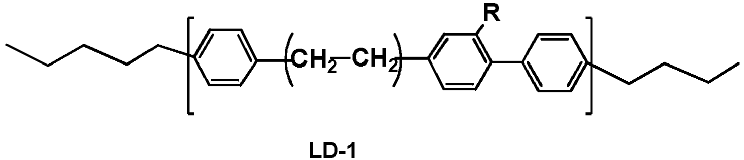 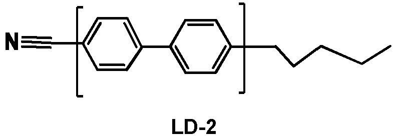 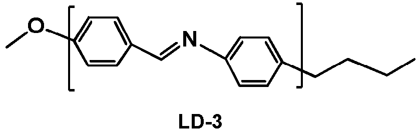 wherein in LD-1 above, R is the same as defined in Formula 1 above.

7. The light control member of claim 3, wherein the base resin region and the light conversion region are portions that are phase-separated in a polymerization process of a light conversion resin composition containing the monomer and the light converters dispersed in the monomer.

8. The light control member of claim 7, wherein the light control layer has a cross-section with a fingerprint pattern formed from the arrangement of the base resin region and the light conversion region that are separated.

9. The light control member of claim 1, wherein the light control layer comprises a division pattern having a plurality of openings defined therein, and first to third light control parts disposed in each of the openings,
the first light control part including the base resin region and a red light conversion region,
the second light control part including the base resin region and a green light conversion region, and
the third light control part including the base resin region and a ligand region in which the liquid crystal ligands are aggregated.

10. The light control member of claim 9, wherein the base resin region has a refractive index different from that of the red light conversion region, that of the green light conversion region, and that of the ligand region.

11. The light control member of claim 9, wherein the red light conversion region comprises a plurality of red light converter, and each of the red light converters comprises a red quantum dot excited by blue light or green light to emit red light and the liquid crystal ligand bonded to a surface of the red quantum dot, and
the green light conversion region comprises a plurality of green light converter, and each of the green light converters comprises a green quantum dot excited by the blue light to emit green light and the liquid crystal ligand bonded to a surface of the green quantum dot.

12. The light control member of claim 11, wherein the first light control part contains the red light converters in an amount of about 20 wt% to about 60 wt% with respect to 100 wt% of a total weight of the first light control part, and
the second light control part contains the green light converters in an amount of about 20 wt% to about 60 wt% with respect to 100 wt% of a total weight of the second light control part.

13. The light control member of claim 9, wherein the third light control part contains the liquid crystal ligand in an amount of about 5 wt% to about 10 wt% with respect to 100 wt% of a total weight of the third light control part.

14. The light control member of claim 9, further comprising a color filter layer disposed on the light control layer, and including a first filter, a second filter, and a third filter that correspond to the first light control part, the second light control part, and the third light control part, respectively.

15. A display device comprising:
a lower panel including a display element layer in which a light emitting region is defined; and
an upper panel including a light control layer that is disposed on the lower panel and includes a division pattern having an opening overlapping the light emitting region defined therein and a light control part disposed in the opening,
wherein the light control layer includes a base resin region, and a light conversion region in which a plurality of light converters are aggregated,
each of the light converters including:
a quantum dot; and
a liquid crystal ligand bonded to a surface of the quantum dot.

16. The display device of claim 15, wherein the base resin region and the light conversion region have different refractive indices.

17. The display device of claim 15, wherein the base resin region comprises a polymer derived from at least one of an acrylate-based monomer or an epoxy-based monomer.

18. The display device of claim 15, wherein the liquid crystal ligand is represented by Formula 1 below: 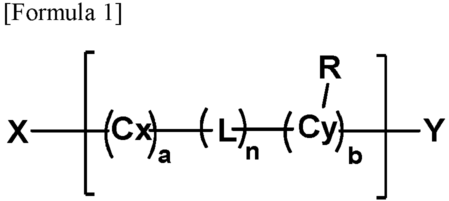
wherein in Formula 1 above,
a and b are each independently an integer of 1 to 3,
n is 0 or 1,
Cx and Cy are each independently a benzene ring or a cyclohexane ring,
L is a divalent ester (COO) group, a divalent ethylene group, a divalent methoxy group, a divalent acetylene group, or a divalent amine group,
R is a hydrogen atom, a halogen atom, a cyano group, a hydroxy group, or a nitro group, and
X and Y are each independently an alkyl group having 1 to 10 carbon atoms, an alkoxy group, a cyano group, or a halogen atom.

19. The display device of claim 15, wherein the light control layer has a cross-section with a fingerprint pattern formed from the arrangement of the base resin region and the light conversion region that are separated.

20. The display device of claim 15, wherein the light control layer comprises:
a first light control part including the base resin region and a red light conversion region separated from the base resin region;
a second light control part including the base resin region and a green light conversion region separated from the base resin region; and
a third light control part including the base resin region and a ligand region separated from the base resin region and having the liquid crystal ligands aggregated therein.

21. The display device of claim 20, wherein the base resin region has a refractive index different from that of the red light conversion region, that of the green light conversion region, and that of the ligand region.

22. The display device of claim 20, wherein the first light control part contains a plurality of red light converters in an amount of about 20 wt% to about 60 wt% with respect to 100 wt% of a total weight of the first light control part, and
the second light control part contains a plurality of green light converters in an amount of about 20 wt% to about 60 wt% with respect to 100 wt% of a total weight of the second light control part, and
the third light control part contains the liquid crystal ligand in an amount of about 5 wt% to about 10 wt% with respect to 100 wt% of a total weight of the third light control part.

23. The display device of claim 20, wherein the display element layer comprises a light emitting element that includes a first electrode, an emission layer disposed on the first electrode, and a second electrode disposed on the emission layer, and outputs source light,
the first light control part comprises a first light converter that converts the source light into a first light,
the second light control part comprises a second light converter that converts the source light into a second light, and
the third light control part transmits the source light.

24. The display device of claim 23, wherein the first light converter comprises a first quantum dot excited by the source light to emit the first light, and the liquid crystal ligand bonded to a surface of the first quantum dot, and
the second light converter comprises a second quantum dot excited by the source light to emit the second light, and the liquid crystal ligand bonded to a surface of the second quantum dot.

25. The display device of claim 23, wherein the upper panel further comprises a filter layer disposed on an upper side of the light control layer, and including:
a first filter overlapping the first light control part and transmitting the first light;
a second filter overlapping the second light control part and transmitting the second light; and
a third filter overlapping the third light control part and transmitting the source light.

26. The display device of claim 15, wherein the light control part does not comprise scatterers.
